Europäisches Patentamt

European Patent Office

Office européen des brevets

(19)

(11) Publication number: **0 178 800**
A2

(12) **EUROPEAN PATENT APPLICATION**

(21) Application number: **85306674.4**

(22) Date of filing: **19.09.85**

(51) Int. Cl.⁴: **H 05 K 5/00**

(30) Priority: **19.09.84 US 652219**

(43) Date of publication of application:
**23.04.86 Bulletin 86/17**

(84) Designated Contracting States:
**DE FR GB IT SE**

(71) Applicant: **DATA GENERAL CORPORATION**
**4400 Computer Drive**
**Westboro Massachusetts 01580(US)**

(72) Inventor: **Boudreau, Marcel**
**Box 851**
**Warren Massachusetts 01083(US)**

(72) Inventor: **Nigro, Arthur R., Jr.**
**15 East Street**
**Hopkinton Massachusetts 01748(US)**

(74) Representative: **Pears, David Ashley et al,**
**REDDIE & GROSE 16 Theobalds Road**
**London WC1X 8PL(GB)**

(54) **Portable computer.**

(57) The computer comprises a housing with a base portion (15) covered at the back by a rear top cover (19) to provide a chamber within which there are disposed the computer electronics and two disc drives with disk insertion slots in the right hand side wall of the housing. The front part of the housing base portion (15) carries a keyboard which can be closed by a front cover (16) hinged to the rear cover (19). The front cover (17), when opened up, exposes an 80 column, 25 line liquid crystal display for the computer. The bottom of the housing base portion (15) has a major flat portion at the rear which provides a suitable base on which the computer rests for lap held use. The front part, beneath the keyboard, inclines upwards and a hinged flap (21) at the rear of the computer can be opened up to tilt the computer onto the inclined front portion of the underside of the base (15). This provides a convenient keyboard and viewing angle for use on a desk surface. The flap (21) also serves, when closed, to cover a rear panel of the computer, provided with various sockets.

FIG. 5

EP 0 178 800 A2

# PORTABLE COMPUTER

The present invention relates generally to portable computers. Although such computers are known they have either (1) not included a built-in display monitor, or (2) not included a display monitor having a full size display screen, or (3) contained only a single disk drive unit, or (4) not included a built-in keyboard, or (5) not included a full size keyboard, or (6) not taken into consideration that the optimum angle of the keyboard for typing when the keyboard is resting on the lap of a user is not the same as the optimum angle of the keyboard for typing when the keyboard is resting on a table top or desk top, or (7) not contained its own power source, or (8) not constructed or shaped so that they can actually fit into an attache case, or (9) not easily and conveniently moved from one location to another.

Having regard to these deficiencies, the present invention provides a portable computer as defined in claim 1.

The means for tilting allow the computer to be seated on a surface to either of one of two angular positions relative to the user.

More specifically, these means enable the keys on the keyboard to be oriented at the optimum angle for use at one position relative to the user when the portable computer is resting on one surface, such as the lap of the user, and to be oriented at the optimum angle for use at another position relative to the user when the portable computer is resting on another surface, such as a desk or table.

The computer preferably has a full size (i.e. 80 columns by 25 lines) display monitor. The keyboard can be a full size (i.e. DIN spaced) keyboard.

The construction of the computer is such that it can include two disc drive units, preferably both on one side of the computer with their disc slots in a side wall of the housing.

The computer can include its own power source. The housing requires a minimum number of parts and can be easily assembled and mass produced.

The invention will be described in more detail by way of example and with reference to the accompanying drawings, in which:

Fig 1 is a perspective view taken from the front of a portable computer embodying the invention, with a front top cover containing the display screen in an open position and a flap at the rear of the portable computer in a closed position;

Fig 2 is a perspective view taken from the back of the computer;

Fig 3 is a back elevation view of the computer with the flap in an open position;

Fig 4 is a right side view of the computer with the front top cover closed;

Fig 5 is a right side view of the computer with the flap in an open position;

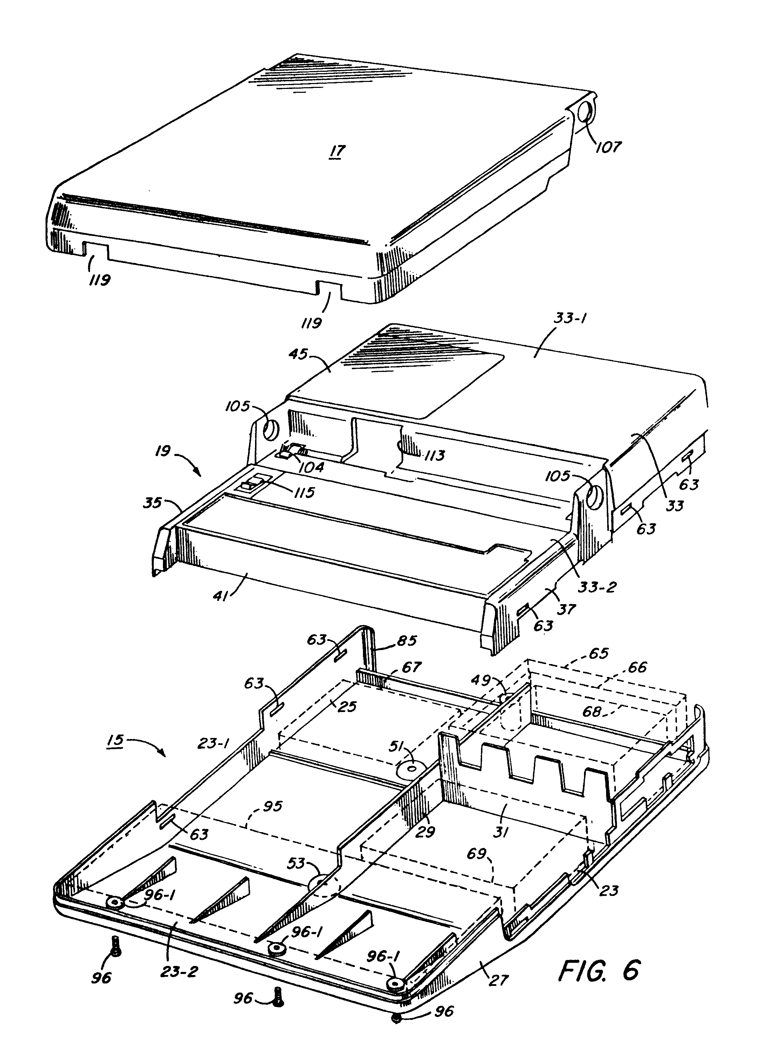

Fig 6 is an exploded perspective view looking down, of the base, top rear cover and top front cover of the housing portion of the computer;

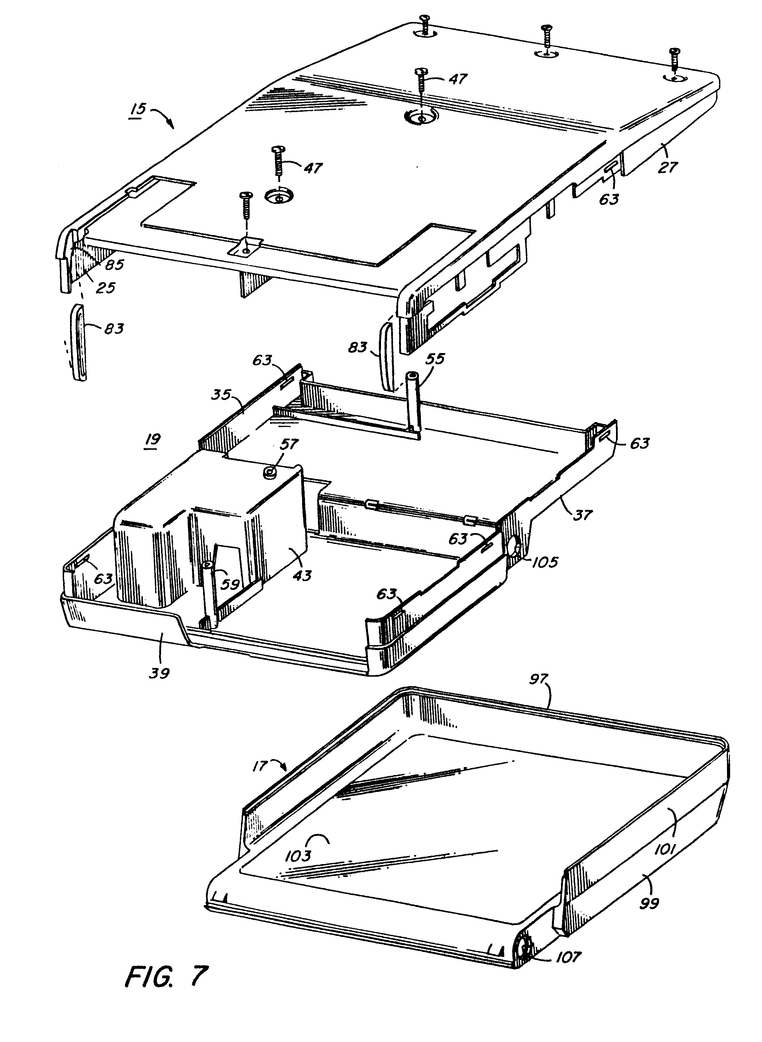

Fig 7 is an exploded perspective view looking up, of the base, top rear cover and top front cover of the housing portion of the computer;

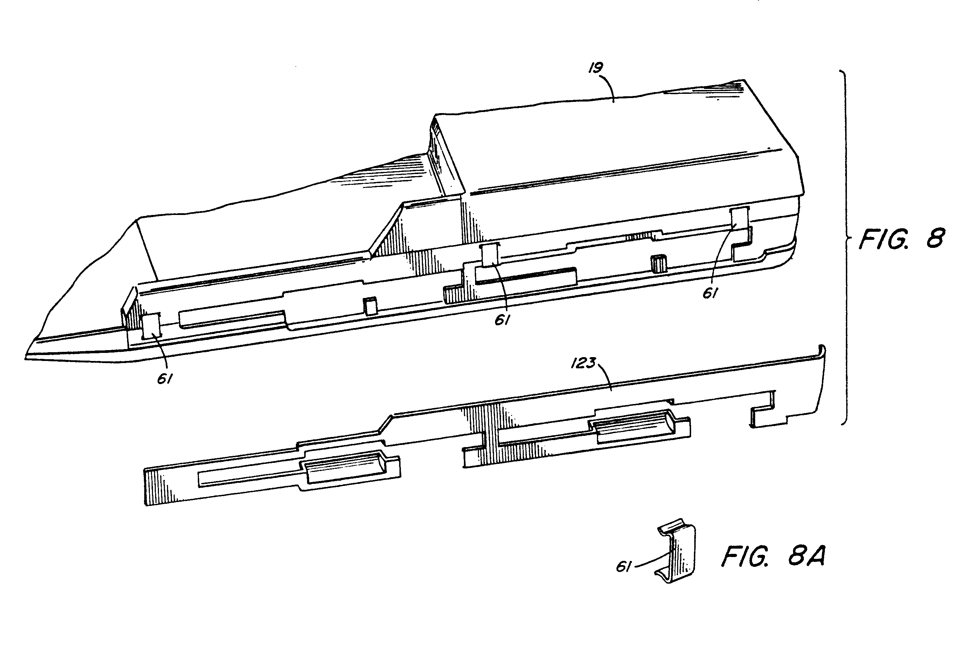

Fig 8 is a perspective view from the right and partly exploded of the computer;

Fig 8A is an enlarged perspective view of one of the spring clips shown in Fig 8;

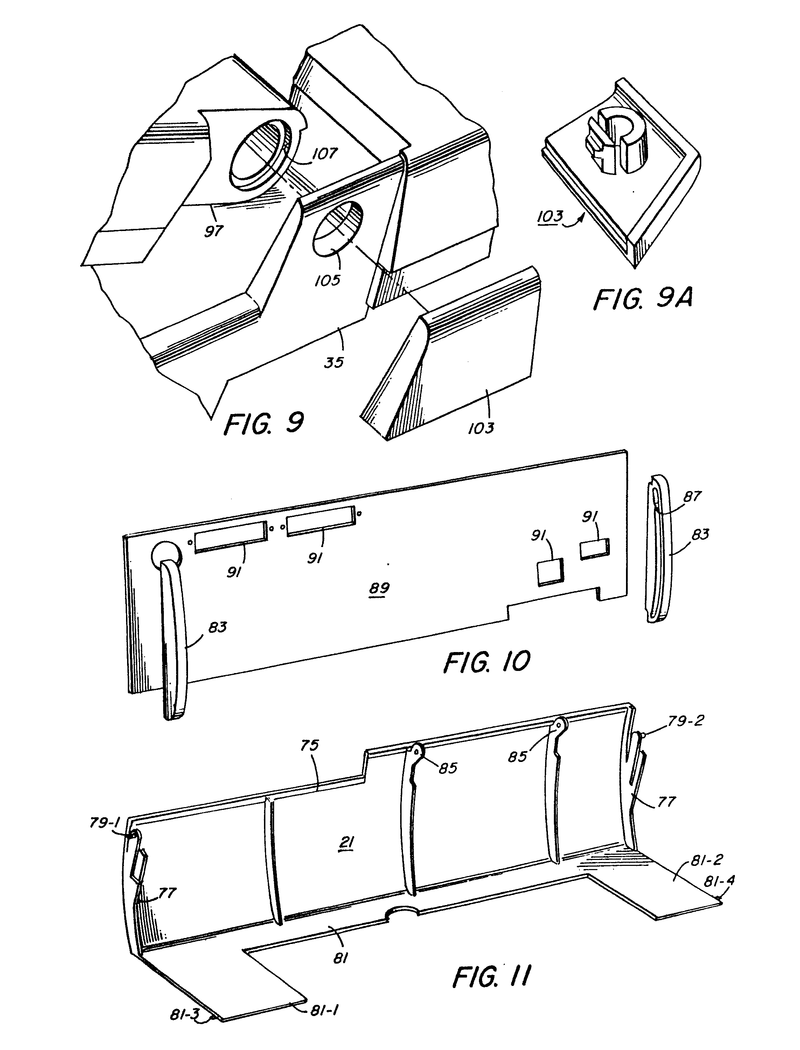

Fig 9 is an enlarged perspective view of a portion of the computer where the front top cover and the rear top cover of the housing are hinged together;

Fig 9A is an enlarged perspective view of a pivot pin shown in Fig 9;

Fig 10 is an enlarged perspective view of bulkhead and channel elements shown in Fig 6; and

Fig 11 is an enlarged perspective view of the flap shown in Fig 3.

A portable computer 11 includes a generally rectangular wedged shaped housing 13 which has a base 15, a front top cover 17, a rear top cover 19 and a flap 21 which acts as a door to a rear panel of the computer. The front top cover 17 extends over the front of the base 15 while the rear top cover 19 extends over the rear of the base 15.

The base 15, which is a unitary structure and made of moulded plastic, includes a generally rectangular bottom wall 23, a leftside

- 3 - 0178800

wall 25 and a right side wall 27. The bottom wall 23 includes a flat back section 23-1 and a flat front section 23-2 inclined upwards to the front relative to back section 23-1 at an angle of about ten degrees. A centre rib 29 which stiffens the base 15 extends along the top surface of the bottom wall 23 and a transverse rib 31 which stiffens the base 15 and also serves as a divider and a mount for some of the printed circuit boards inside the computer 11 extends at right angles to the centre rib 29 along the top surface of the bottom wall 23.

The rear top cover 19, which is a unitary structure and is made of moulded plastic, includes a rectangular stepped top wall 33 having a rear section 33-1 and a front section 33-2 which is lower than the rear section, a left side wall 35, a right side wall 37, a back wall 39, a front wall 41 and a recessed portion which defines a battery compartment 43. A removable battery compartment cover 45 is slidably mounted on the rear top cover 19.

The rear top cover 19 is secured to the base 15 by three screws 47 which extend up from the bottom through three bosses 49, 51, and 53 in base 15 into three threaded bosses 55, 57, and 59 in the top cover 19, and six spring clips 61 which snap fit into rectangular slots 63 formed in the side walls of the rear top cover 19 and base 15, three on each side. When the rear top cover 19 is secured to the base 15, the bottom edges of the left side wall 35 and right side wall 37 are seated on the top edges of the left side wall 25 and right side wall 27 of the base 15, with the space between base 15 and rear top cover 19 defining a chamber which extends from the back of the housing 13 to the front section 23-2 of the bottom wall 23. Thus, the rear top cover 19 serves as a cover only for the rear portion of the base 15.

The electronics portion of portable computer 11 (i.e. printed circuit boards etc) shown symbolically as boxes 65, 66 and 67 are disposed in the left and right rear portions of the housing chamber while first and second disk drive units, shown symbolically as boxes 68 and 69, are disposed in the right portion of the housing chamber.

The right side wall 27 of the base 15 is configured to provide slots 71 and 73 through which disks may be inserted into the disk drive units 67 and 69.

The flap 21, which is a unitary structure and is made of moulded plastic, includes a rectangular, slightly curved back wall 75, a pair of side sections 77 having guide pins 79-1 and 79-2 and a bottom wall 81 having legs 81-1 and 81-2 which include guide pins 81-3 and 81-4.

Two arcuate channel elements 83 are seated in slots 85 formed in the side walls 25 and 27 of the base 15, one at each end corner.

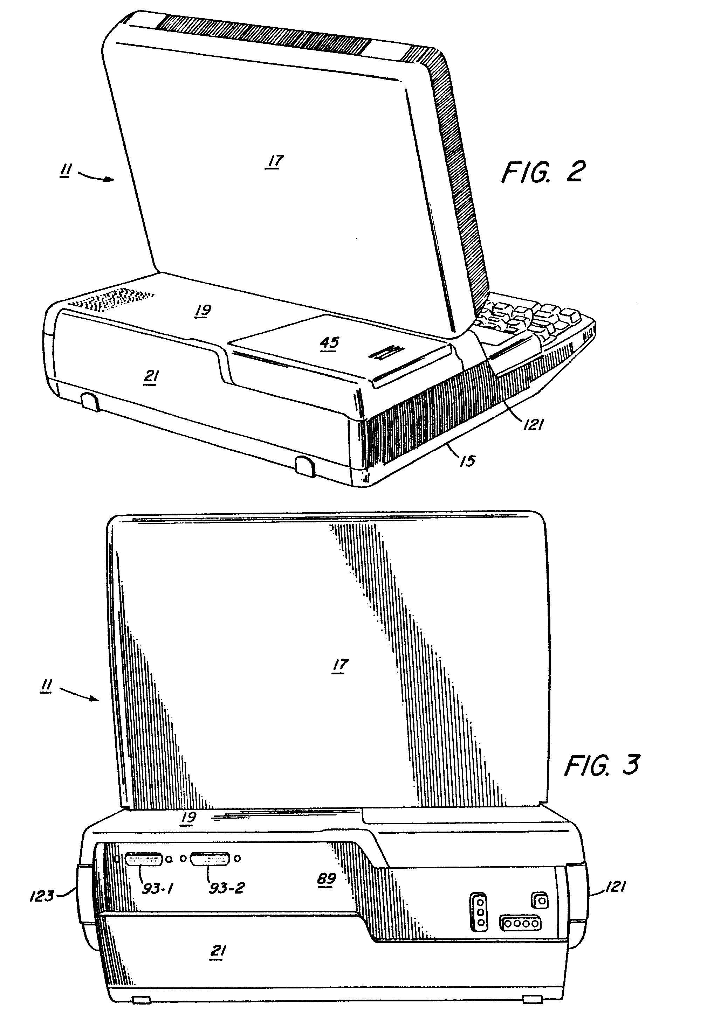

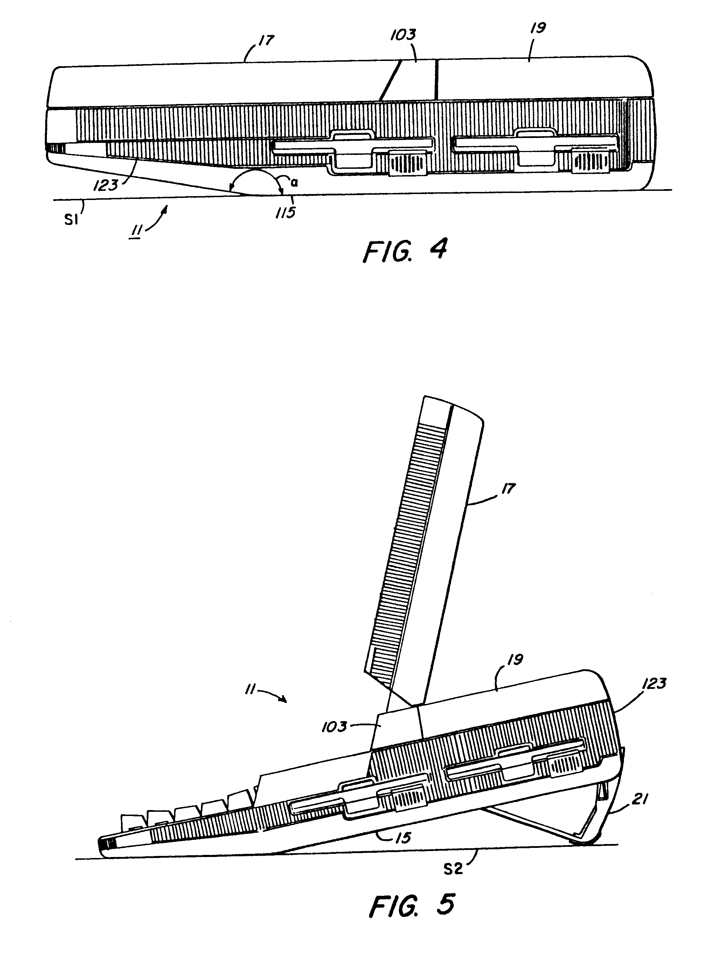

The flap 21 is movably mounted on the base 15 with the legs 81-1 and 81-2 extending into recessed areas 23-3 in the bottom wall 23 and the guide pins 79-1 and 79-2 riding in the channel elements 83. As so mounted, the flap 21 may be moved to either an open position (as shown in Fig 5) or a closed position (as shown in Fig 2). A pair of resilient locking tabs 85 on the flap 21 provide a positive type of locking when the flap 21 is in a closed position and detents 87 on the channel elements 83 provide positive locking when the flap 21 is in an open position.

A flat rectangular metal plate 89 is disposed in base 15 as the rear panel of the computer and has a plurality of slots 91 in which are mounted various connectors 93-1, 93-2, etc for use in connecting the electronics in portable computer 11 to external electrical devices (not shown) such as a modem or a main computer.

A full size keyboard 95 is seated on the top surface of the front section 23-2 of the bottom wall 23 of the base 15 and is fixed thereto by means of three screws 96 which extend upward from the bottom of front section 21-2 into bosses 96-1. The back end of keyboard 95 extends partly into the chamber defined by the base 15 and rear top cover 19.

The front top cover 17 includes a support 97 made up of a back plate 99 and a bezel 101. A full size (i.e. 80 columns by 25 lines) liquid crystal (LCD) display 103 is fixed on the support 97. The LCD display 103 includes a clear plastic protective plate 103-1. The front top cover 17 is hinged on the rear top cover 19 by a pair of moulded in plastic pin elements 103 which extend through holes 105 formed in ears 107 on the side walls 35 and 37 of the rear top cover 19 and snap fit into holes 109 formed in the support 97.

A set of batteries (not shown) for powering the computer 11 are disposed in the battery compartment 43.

The LCD display 103 is electrically connected to the computer electronics inside the housing chamber by a cable 111, which extends down into the chamber of the housing 13 through a slot 113 formed through the step in the rear top cover 19. A switch 115 for turning the portable computer on and off is fixedly mounted on the top cover 19. The protective plate 101 includes a detent 117 which presses down on the switch 115 and places it in the "off" position when top front cover 17 is closed. Latches 119 on the top front of the top front cover 17 serve to hold the top front cover 17 in a closed position.

Left and right trim plates 121 and 123 are snap fits on to the sides of the housing 13 and held in place by detents 125. The right trim plate 123 is configured to allow disks to be inserted into the disk drive units in the chamber of the housing 13.

The flap 21 serves three purposes, namely, (1) it serves as a cover to prevent damage to the connectors on the rear panel 89, (2) it serves to provide a smooth surface for holding the portable computer 11 from the back end when it is being moved and (3) it enables the portable computer 11 to rest on a surface at either one of two different angles. More particularly, when the flap 21 is in a closed position, the back section 23-1 of the bottom wall 23 rests on the surface on which computer 11 is placed (surface S1 in Fig 4). When the flap 21 is in an open position the front section 23-2 of the bottom wall 23 and the bottom edge of the flap 23 rests on the surface on which computer 11 is placed (surface S2 in Fig 5).

When the computer is on the lap of a user, the optimum angular position of the keys of keyboard 95 relative to the hands of the user is achieved with the flap 21 in a closed position. On the other hand, when the computer 11 is on a desk or table the optimum position of the keys of keyboard 95 relative to the hands of the user is achieved when the flap 21 is in an open position.

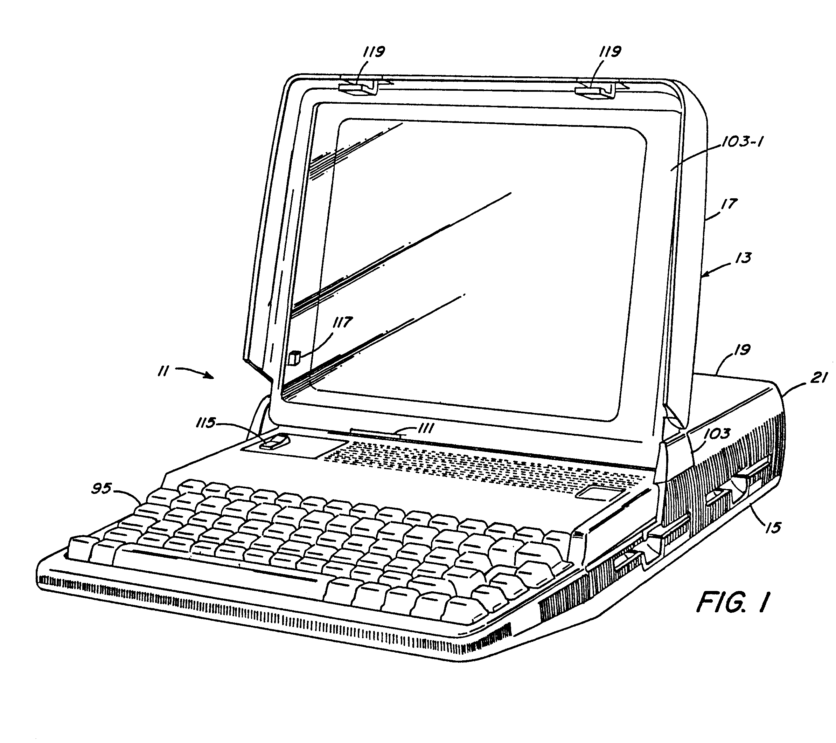

The front top cover 17 serves two purposes, namely (1) it functions as a holder for the LCD display 103 and (2) it serves as a cover for the keyboard 95. When front top cover 17 is flipped up in an open position (as shown in Fig 1) spring tabs 104 lock cover 17 in the open position and the optimum viewing angle for LCD display 103 is between the viewing angle when the flap 21 is open and when foot door 21 is closed.

When the front top cover 17 and the flap 21 are both in their closed position, the computer has a rectangular, wedge shaped configuration.

An embodiment of the portable computer has been constructed wherein the overall size dimensions are about 297 mm by about 348 mm by about 71 mm and the weight is about 4.75 kg. The keyboard is a low profile, non-encoded keybaord employing tactile feedback, conforming to ECMA guidelines, made by Fujitsu Corporation and having overall dimensions of around 290.5 mm by 123 mm by 19mm.  The LCD display is made by Epson Corporation and has overall dimensions of around 198 mm by 270 mm by 14 mm.  The disk drive units are 3½ inch size diskette subsystems manufactured by Epson Corporation and having dimensions of around 101.6 mm by 147.5 mm by 32 mm.  The battery pack contains ten NiCad D cells in a shrunk wrap package and is made by Matsushita Corporation.

**0178800**

CLAIMS

1. A portable computer, characterised by the combination of a housing (13) adapted to rest on a surface, the housing having a front and a rear and including means (21) for tilting the housing in a forward direction on the surface on which it rests, computer electronics (65, 66, 67) in the housing, at least one disk drive (68, 69) in the housing, a keyboard (95) in the housing, and a display monitor (103) in the housing.

2. A computer according to claim 1, characterised in that the housing (13) includes a base (15) and a rear top cover (19) fixed to the base.

3. A computer according to claim 2, characterised in that the means for tilting the housing (13) in a forwardly direction comprises a flap (21) mounted on the base (15) and movable from a closed position to an open position.

4. A computer according to claim 3, characterised in that the base (15), rear top cover (19) and flap (21) are unitary structures made of moulded plastics material.

5. A computer according to claim 3 or 4, characterised in that the flap (21) is mounted on the rear of the base (15).

6. A computer according to claim 5, characterised in that the flap (21) also serves, when closed, as a cover for a rear panel (89) of the computer.

7. A computer according to any of claims 2 to 6, characterised in that the base (15) has a bottom wall having a front section (23-2) and a rear section (23-1) inclined upwardly from the front section.

8. A computer according to any of claims 2 to 7, characterised by a front top cover (17) pivotally attached to the rear top cover (19).

9. A computer according to claim 8, characterised in that the display monitor (103) is fixed on the front top cover (17).

10. A computer according to claim 9, characterised in that the display monitor (103) includes a full screen liquid crystal display.

11. A computer according to claim 8, 9 or 10, characterised in that the front top cover (17) includes a cover plate (99) and a bezel (101).

12. A computer according to any of claims 1 to 11, characterised in that the keyboard (95) is a full size keyboard.

13. A computer according to any of claims 1 to 12, characterised in that there are two disk drive units (68 and 69).

14. A computer according to any of claims 1 to 13, characterised by a battery pack removably mounted in the housing (13).

15. A housing for a portable computer, characterised by a base (15) having a front and a rear, a rear top cover (19) fixed to the base and defining along with said base a chamber adapted to hold the electrical and mechanical components of the portable computer, the front of the base being adapted to hold a computer keyboard, a flap (21) mounted on the base and movable between a first position and a second position, and a front top cover (17) hinged on the rear top cover and adapted to hold a display monitor.

16. A housing according to claim 15, characterised in that the housing has a generally rectangular wedge shaped configuration when the flap and front top cover are both in their closed position.

FIG. 1

FIG. 2

FIG. 3

FIG. 4

FIG. 5

*FIG. 6*

FIG. 7

0178800

FIG. 8

FIG. 8A

19

123

61

0178800

107

97

105

35

FIG. 9

103

FIG. 9A

103

87

91

91

91

83

91

91

89

83

FIG. 10

75

79-2

85

85

77

79-1

21

81-2

81-4

77

81

81-3

81-1

FIG. 11